Europäisches Patentamt

European Patent Office

Office européen des brevets

(11) Publication number: **0 232 619 B1**

# EUROPEAN PATENT SPECIFICATION

(45) Date of publication of patent specification: **25.03.92**

(51) Int. Cl.⁵: **H01L 21/205**, H01L 29/72, C23C 16/24

(21) Application number: **86310103.6**

(22) Date of filing: **23.12.86**

(54) Method of manufacturing a thin-film transistor.

(30) Priority: **26.12.85 JP 292312/85**

(43) Date of publication of application:
**19.08.87 Bulletin 87/34**

(45) Publication of the grant of the patent:
**25.03.92 Bulletin 92/13**

(84) Designated Contracting States:
**DE FR GB IT NL**

(56) References cited:
**GB-A- 2 083 705**
**US-A- 4 546 008**

**PHILIPS TECHNICAL REVIEW, vol. 41, no. 2, 1983/84, pages 60-69, Eindhoven, NL; J. BLOEM et al.: "Nucleation and growth of silicon films by chemical vapour deposition"**

**JOURNAL OF APPLIED PHYSICS, vol. 54, no. 11, November 1983, pages 6385-6389, New York, US; S. SUZUKI et al.: "Epitaxial growth of Si-Ge layers on Si substrates by plasmal dissociation of SiH4 and GeH4 mixture"**

(73) Proprietor: **CANON KABUSHIKI KAISHA
30-2, 3-chome, Shimomaruko, Ohta-ku
Tokyo(JP)**

(72) Inventor: **Ishihara, Shunichi
600-5-7-404, Kashiwagaya
Ebina-shi Kanagawa-ken(JP)**
Inventor: **Ootoshi, Hirokazu
839, Namuse
Machida-shi Tokyo(JP)**
Inventor: **Hirooka, Masaaki
2139-19, Ino
Toride-shi Ibaragi-ken(JP)**
Inventor: **Hanna,Junichi
5780, Nagatsuda-cho Midori-ku
Yokohama-shi Kanagawa-ken(JP)**
Inventor: **Shimizu, Isamu
2-41-21, Fujigaoka Midori-ku
Yokohama-shi Kanagawa-ken(JP)**

(74) Representative: **Beresford, Keith Denis Lewis et al
BERESFORD & Co. 2-5 Warwick Court High Holborn
London WC1R 5DJ(GB)**

## Description

This invention relates to a process for forming a thin-film transistor. In particular, it relates to a process in which at least one of the principal semiconducting layers of a thin-film transistor, a layer composed of an amorphous material, is prepared by a chemical reaction of a specific gaseous substance with a gaseous halogen-containing substance in the absence of a plasma.

A number of methods have been proposed for the preparation of amorphous or polycrystalline films such as semiconducting film, insulative film, photoconductive film, magnetic film or metallic film for use in thin-film transistor (TFT) or the like, which methods are adapted to produce films having desired physical characteristics for specific applications.

For instance, for the preparation of a deposited silicon-containing film, namely, a non-monocrystalline silicon film of which unpaired electrons are compensated with a compensating agent such as hydrogen atoms (H) or halogen atoms (X) [hereinafter referred to as "NON-Si(H,X)"] such as an amorphous silicon film of which unpaired electrons are compensated with said compensating agent [hereinafter referred to as "a-Si(H,X)"] or polycrystalline silicon film of which unpaired electrons are compensated with said compensating agent [hereinafter referred to as "poly-Si(H,X)"], wherein the so-called crystallite silicon film lies in the range of the aforesaid a-Si(H,X) as a matter of course, there have been proposed various methods using vacuum evaporation, heat chemical vapor deposition, plasma chemical vapor deposition, reactive sputtering, ion plating or light chemical vapor deposition, techniques.

Methods using plasma vapor deposition (hereinafter referred to as "plasma CVD method") have been generally recognised as being the most preferred amongst these alternatives and are currently used on a commercial basis. J. Appl. Phys. 54 pages 6385-6389 shows a typical plasma CVD process for deposition of Si-Ge layers.

However, the operation conditions to be employed for plasma CVD are much more complicated than those for the known CVD method, and it is extremely difficult to generalise them.

That is, there already exist a number of variations even in the correlated parameters, i.e. the temperature of the substrate, the amount and the flow rate of gases to be introduced, the pressures and the high frequency power level used for forming film, the electrode structure, the structure of the reaction chamber, the flow rate of exhaust gases and the plasma generation system. Besides these parameters, there also exist other kinds of parameters. Under these circumstances, in order to obtain a desired deposited film product it is required to choose precise parameters from a great number of varied parameters. Sometimes, serious problems occur. Because of the precision required in the chosen parameters, the plasma is apt to be in an unstable state. This condition often leads to problems during film deposition.

In addition, since a plasma is directly generated by the action of a high-frequency wave or a microwave in a film forming space wherein the substrate is placed, the electrons or ion species resulting can in turn give rise to damage in the deposited film. In such case, the resulting film produced can exhibit an undesirable unevenness in its properties and a deterioration in its quality.

Apparatus for a process using the plasma CVD method is likely to be complicated since the parameters employed have to be chosen precisely and well controlled as stated above.

Whenever the scale or the kind of the apparatus to be used is modified or changed, the apparatus must be so structured as to cope with the precisely chosen parameters.

In this regard, even if a desirable deposited film should be fortuitously mass-produced, the film product becomes unavoidably costly because (1) a heavy investment is firstly necessitated to set up a particularly appropriate apparatus therefor; (2) a number of process operation parameters even for such apparatus still exist and the relevant parameters for the mass-production of such film. In accordance with such precisely chosen parameters, the process must then be carefully controlled.

As a solution to solve those problems as mentioned above, the so-called indirect plasma CVD method has been proposed.

The indirect plasma CVD method comprises generating plasma in an upper stream space apart from the film forming space with microwave energy or the like and transporting the plasma to the film forming space including the substrate so that chemical species are selectively utilised to form a deposited film on the substrate.

However, in this indirect plasma CVD method, as a plasma is generated not in the film forming space but in a different space apart therefrom and the plasma is then transported to the film forming space, the life span of the chemical species must be long enough to form a deposited film. In this connection, for this indirect plasma CVD method, there exist problems. That is firstly, only limited kinds of deposited film can be obtained because the kinds of starting gas that can be employed are limited to those that result in chemical species having sufficient long life span. Secondly, a large quantity of energy is necessitated for the generation of plasma in the aforesaid space. Thirdly, the generation of a chemical species capable of contributing in forming a deposited film and which has a sufficiently long enough life span cannot be easily attained. Finally, it is difficult to maintain the amount of such a chemical species during the formation of the deposited film.

Besides this indirect plasma CVD method, there have been attempts to use light chemical vapor deposition (hereinafter referred to as "light CVD method").

For the light CVD method, although electron or ion damage to the film is avoided, there exist other problems.

Firstly, in practice, only a limited number of light sources are suitable for such use. Secondly, even for such a light source, the chosen wavelength tends to be at the ultraviolet end of the spectrum. Therefore a large scale light source and a particular power source are necessitated.

Thirdly, since the inner surface of the light transmission window gradually becomes coated with film during the film forming process, the quantity of light incident through the transmission window into the film forming space eventually decreases and film deposition on the substrate is retarded accordingly.

Against this background, there is now an increased demand for a method that would make it possible to produce film at a high film-forming rate whilst involving only simple procedure in order to mass-produce a desired semiconducting film e.g. for a thin-film transistor. The film produced is desired to have good uniformity and also many practically applicable characteristics so that the product can be relatively inexpensive.

Likewise, there are similar situations which exist in producing other kinds of semiconducting film for thin-film transistor, such as silicon : nitrogen film, silicon : carbon film and silicon : oxygen film.

The present inventors have conducted extensive studies in order to solve the problems in the aforementioned known methods and in order to develop a new process for effectively and simply preparing a desired functional deposited film usable as a principal semiconducting layer for a thin-film transistor (for instance an amorphous silicon film which has an abundance of practically applicable characteristics), without depending upon any known method and which meets the above-mentioned demand.

As a result, the present inventors finally found a process that enables one to efficiently and stably form said film in simplified particular procedures as defined in the claims.

Each of the embodiments of this invention, detailed below, provide an improved thin-film transistor of which at least one of the principal semiconducting layers comprises a high quality functional film having an abundance of practically applicable electrical, optical and/or semiconductive characteristics, composed of an amorphous material and prepared by chemically reacting (i) a substance which contributes in forming said film and (ii) a halogen containing substance which reacts with said substance (i) in the absence of a plasma.

Also, each of the embodiments of this invention, detailed below, provides a process for preparing the above film using a gaseous substance which contributes in forming the above film and a gaseous halogen containing substance which can oxidise the gaseous substance, in the absence of a plasma, to form the above film on a substrate in a film forming space of a closed system at a high film-forming rate.

In the accompanying drawings:

Figure 1 is a schematic explanatory view of a representative fabrication apparatus for preparing a thin-film transistor according to this invention;

Figure 2 is a cross-sectional portion view of a representative thin-film transistor according to this invention.

So that this invention may be best understood, preferred embodiments thereof will now be described and reference will be made to the drawings. The description that follows is given by way of example only.

Each process, to be detailed below, comprises: selecting (i) a substance which can be a constituent for a semiconducting layer to be formed but which does not or can hardly contribute in forming the foregoing layer as long as it remains in its original energy state (hereinafter referred to as "substance A") and (ii) a halogen-containing substance which can react with the substance A to oxidise it (hereinafter referred to as "oxidising agent"); introducing the two substances in gaseous state into a film forming chamber, wherein a substrate is placed while being maintained at a predetermined temperature, separately through respective transporting conduits; chemically reacting the two substances in the absence of a plasma to generate a mixture of precursors containing excited precursors; and forming the layer on the substrate using at least one of the precursors of the mixture.

The following advantages can result: a desired semiconducting layer for a thin-film transistor which has a uniform thickness and a desirable homogeneity may be effectively formed at an improved film forming rate in simple procedures without consumption of so much energy as in so many of the conventional methods; the operation parameters for preparing a semiconducting layer for a thin-film transistor may be

EP 0 232 619 B1

largely simplified; an improved thin-film transistor having such a desired semi-conducting layer may be mass-produced on an industrial scale to thereby reduce the cost of production; and without so much heavy investment in developing particular apparatus.

The starting substance to be used as the foregoing substance A (which contributes in forming a semiconducting layer for the thin-film transistor of this invention) means a substance which can be a constituent for said layer but which does not contribute appreciably in forming said layer while it remains in its original energy stage, as previously mentioned. But it is required that the substance A shall generate a mixture of precursors, including excited precursors, when it is reacted with the foregoing halogen containing oxidising agent.

The substance A is selected appropriately in accordance with the kind, the expected characteristics to be exhibited, and/or the function, of the desired semiconducting layer.

For the substance A, any gaseous, liquid or solid substance may be used as long as it meets the above conditions, and it can be presented readily in a gaseous state to be chemically reacted with said oxidising agent.

When a liquid or solid substance is employed as the substance A, it is bubbled using an inert gas such as Ar, He, $N_2$ or $H_2$ and, if necessary, while being heated, to provide a gaseous form of the substance, so that it can be introduced into the film forming chamber.

Examples of the substance A for forming a semiconducting and/or insulative film such as a group IVA element-containing deposited film e.g. silicon-containing deposited film or germanium-containing film, are straight chain silane compounds, branched chain silane compounds, cyclic silane compounds and chain germanium-containing compounds.

Specific examples are $Si_nH_{2n+2}$ (n = 1, 2, 3, 4, 5, 6,7 or 8) for the straight chain silane compound; $SiH_3SiH(SiH_3)SiH_2SiH_3$ for the branched silane compound; and $Ge_mH_{2m+2}$ (m = 1, 2, 3, 4 or 5) for the chain germanium-containing compound.

Other than these compounds, there can be used tin-containing compounds such as tin halide e.g. $SnH_4$ as the substance A in the case of forming a tin-containing deposited functional film.

For the foregoing halogen containing oxidising agent, a gaseous substance is used. There are also other requirements for the oxidising agent.That is, the oxidising agent must be such that it has the property of easily causing an excitation for the substance A due to the electronical oxidation action of the oxidizing agent at the time of chemical contact between the two substances. Therefore, examples of such oxidising agents are halogen gases such as $F_2$, $Cl_2$, $Br_2$ and $I_2$, and other than these, nascent halogens such as nascent fluorine, chlorine and iodine.

The aforementioned substance A and the aforementioned halogen containing oxidising agent are introduced separately through respective transporting conduits into a film forming chamber with an appropriate flow rate and under an appropriate pressure condition to collide with each other and cause chemical reaction between the two substances to generate a mixture of precursors including excited precursors. At least one of these resulting precursors is directed to form a deposited film as semiconducting layer on the substrate and is maintained at a predetermined temperature in the film forming chamber.

In the above film forming process, the excited precursor generated therein becomes a different precursor or a different excited precursor through successive decomposition or chemical reaction, or it sometimes liberates energy. The excited precursor comes into contact with a surface of the substrate while maintained at a predetermined temperature in the film forming space and thus brings about the formation of a deposited film having a three dimensional network structure on the substrate. In this system, the energy level of the excited precursor generated as a result of the contact between the substance A and the oxidising agent is preferred to be either such that it can transit to a lower energy level or such that it is accompanied with an emission during the process when the excited precursor is changed into other chemical species. Because of the generation of mixed precursors containing such excited precursor as being accompanied with the emission of energy, the formation process of the semiconducting layer is effectively performed with a lower consumption of power energy and results in obtaining an improved thin-film transistor having a desired semiconducting layer with a uniform thickness and a desired homogeneity and also excellent semiconductive characteristics.

The combination of the substance A and the oxidising agent is selected appropriately according to the chosen kind of semiconducting film to be formed on the substrate.

The electrical conductivity and/or the electrical conduction type of the semiconducting layer to be formed can be controlled by incorporating either an element of Group IIIA of the Periodic Table (hereinafter referred to as "group IIIA atom") or an element of Group VA of the Periodic Table (hereinafter referred to as "group VA atom") in the semiconducting film.

The incorporation of the group IIIA atom or the group VA atom in the semiconducting layer is carried

4

out by doping the film during its formation process.

As the group IIIA atoms, B, Al, Ga, In and Tl can be introduced. As the group VA atoms: N, P, As, Sb and Bi can be introduced. Among these atoms, B, Ga, P and Sb are preferred most.

For the starting substance to impart such atoms, either a gaseous substance or gasifiable substance containing such atoms as the constituents are employed.

Specific examples are $PH_3$, $P_2H_5$, $PCl_3$, $AsH_3$, $AsCl_3$, $SbH_3$, $BiH_3$, $BCl_3$, $BBr_3$, $B_2H_6$, $B_4H_{10}$, $B_5H_9$, $B_5H_{11}$, $B_6H_{10}$, $B_6H_{12}$ and $AlCl_3$.

The starting substance to impart nitrogen atoms (N) can include nitrogen ($N_2$), nitrogen monoxide (NO), ammonia ($NH_3$), hydrazine ($H_2NNH_2$), hydrogen azide ($HN_3$) and ammonium azide ($NH_4N_3$) Other than these compounds, compounds comprising C and H as the constituents such as saturated hydrocarbons of 1 to 4 carbon atoms, ethylenic hydrocarbons of 2 to 4 carbon atoms and acetylenic hydrocarbons of 2 or 3 carbon atoms can be used as requisite.

Specifically, the saturated hydrocarbons can include methane ($CH_4$), ethane ($C_2H_6$), propane ($C_3H_8$), n-butane (n-$C_4H_{10}$) and pentane ($C_5H_{12}$), the ethylenic hydrocarbons can include ethylene ($C_2H_4$), propylene ($C_3H_6$), butene-1 ($C_4H_8$), butene-2 ($C_4H_8$), isobutylene ($C_4H_8$) and pentene ($C_5H_{10}$) and the acetylenic hydrocarbons can include acetylene ($C_2H_2$), propyne ($C_3H_4$) and butyne ($C_4H_6$).

As for the substrate, it may be either electroconductive or electrically insulative. The shape of the substrate is optional. The shape may be drum, belt, plate or the like, for example.

The thickness of the substrate is optional. But it is usually not less than 10 microns in view of fabrication and handling, or the mechanical strength desired of the substrate.

Examples of the electroconductive substrate are metals such Al, Cr, Mo, Au, Ir, Nb, Ta, V, Ti, Pt, Pd and the like, or alloys such as NiCr, stainless steel or alloys of said metals.

Examples of the electrically insulating substrate are films or sheets of synthetic resin such as polyester, polyethylene, polycarbonate, cellulose acetate, polypropylene, polyvinyl chloride, polyvinylidene chloride, polystyrene, polyamide and the like, as well as glass and ceramics. For the electrically insulating substrate, it is desirable that at least one surface thereof is made conductive.

For example, in the case of glass, its surface may be made conductive by applying a thin layer of metal, such as NiCr, Al, Cr, Mo, Au, Ir, Nb, Ta, V, Ti, Pt, or Pd, or an oxide, such as $In_2O_3$, $SnO_2$, or ITO ($In_2O_3$ + $SnO_2$). In case of synthetic resin film such as polyester film etc., its surface may be made conductive with a metal such as NiCr, Al, Ag, Pd, Zn, Ni, Au, Cr, Mo, Ir, Nb, Ta, V, Ti, or Pt. Vacuum vapor deposition techniques, electron beam vapor deposition techniques or sputtering techniques may be used to apply the conductive layer. Alternatively its surface may be made conductive by laminating it with one of the above metals.

As for the substrate to be used, an appropriate one is selected from those mentioned above, while taking due account of its adhesiveness and reactivity with the film that is to be formed thereon.

It is also preferable to match the expansion coefficients of the substrate and deposition layer so to result in a strain-free layer.

The surface state of the substrate is also chosen to obviate any problem in the structure and texture of the semiconducting layer.

In this process for preparing an improved thin-film transistor, the conditions upon forming the corresponding semiconducting layer, for example, the combination of the substance A with the oxidising agent, their mixing ratio, the gas pressure upon mixing those substances in the film forming chamber, their gas flow rates, the internal pressure upon forming the layer on the substrate, the carrier gas flow rate, the temperature of the substrate and the flow type of each gaseous substance when introduced into the film forming chamber are significant factors for obtaining a layer having desired characteristics, and they are selected appropriately while giving consideration to the functions of the layer that is to be formed.

Further, since these layer forming conditions are organically correlated and may be varied depending upon the kind and the amount of each of the atoms contained in the layer, the conditions are to be determined taking these relationships into consideration.

The volume ratio of the substance A to the oxidising agent on the basis of the flow ratio is preferably 1/20 to 100/1, and more preferably, 1/5 to 50/1.

The gas pressure in the film forming chamber when the substance A is mixed with the oxidising agent is preferred to be higher in order to facilitate their chemical reaction. But it is necessary to determine this with due regard to the reactivities. Therefore, it is preferably $1 \times 10^{-2}$ to $10^6$ Pa ($1 \times 10^{-7}$ to 10 atmospheres) and more preferably $1 \times 10^{-1}$ to $3 \times 10^5$ Pa ($1 \times 10^{-6}$ to 3 atmospheres).

The internal pressure in the film forming chamber, namely, the pressure of the inner space wherein the substrate is placed, is determined appropriately with due regard to the excited precursors that are to be generated in the above inner space and to the conditions which allow those precursors, derived from the excited precursors, to become effective in forming the deposited layer.

Where the reaction region is open-connected to the film forming region, the internal pressure in the film forming chamber can be adjusted with the use of a differential exhausting means or a large scale exhausting device while having due regard to the correlated conditions relating to the introducing pressure and the introducing flow rate for each of the gaseous substance A and the gaseous oxidising agent when they are introduced into the reaction region of the film forming chamber.

Where the conductance of the connecting part between the reaction region and the film forming region is relatively small, the internal pressure in the film forming region can be adjusted by controlling the amount of the exhaust gas by operating an exhaust device connected to the film forming region.

Further in the case where the reaction region and the film forming region are united and they are not structurally separated, it is desirable to conduct the gas exhaustion with a differential gas exhausting means or with a large scale gas exhausting device.

As mentioned above, the internal pressure in the film forming chamber is chosen with due regard to the correlative pressure conditions for introducing the gaseous substance A and the gaseous oxidising agent into the film forming chamber.

However, in general, the internal pressure is preferably $1.3 \times 10^{-1}$ to $1.3 \times 10^4$ Pa (0.001 to 100 Torr), more preferably 1.3 to $4 \times 10^3$ pa (0.01 to 30 Torr) and most preferably 6.6 to $1.3 \times 10^3$ pa (0.05 to 10 Torr).

The form of the gas flow into the film forming space for each of the foregoing substances, is chosen appropriately with due regard to the geometrical arrangement of the gas flow inlet, the substrate and the gasflow outlet so that the gaseous substance A and the gaseous oxidising agent are effectively introduced into and homogeneously and well mixed in the predetermined region of the film forming chamber to generate desired precursors and to bring about the effective formation of a deposited film on the substrate.

The temperature of the substrate upon forming a deposited film thereon is properly determined according to the kind of gaseous substance to be employed and also to the kind of deposited film that is to be formed.

That is, in the case of forming a deposited film composed of an amorphous material, the temperature is preferably room temperature to 450°C, and more preferably, in the range 50 to 400°C.

In particular, in the case of forming a deposited film having an abundance of excellent semiconductive characteristics and photoconductive characteristics, it is most preferably 70 to 350°C.

Further, in the case of forming a deposited polycrystalline amorphous film, the temperature is preferably in the range 200 to 650°C, and more preferably, in the range 300 to 600°C.

The ambient temperature in the film forming space is properly determined with due regard to the temperature of the substrate so that desired precursors are effectively generated, and those precursors as generated and other precursors derived from the former precursors are not changed into undesired products during the film forming process in the film forming chamber.

This invention will now be described in more detail by reference to the following Examples 1 to 4, which are provided here for illustrative purposes only, and are not intended to limit the scope of this invention.

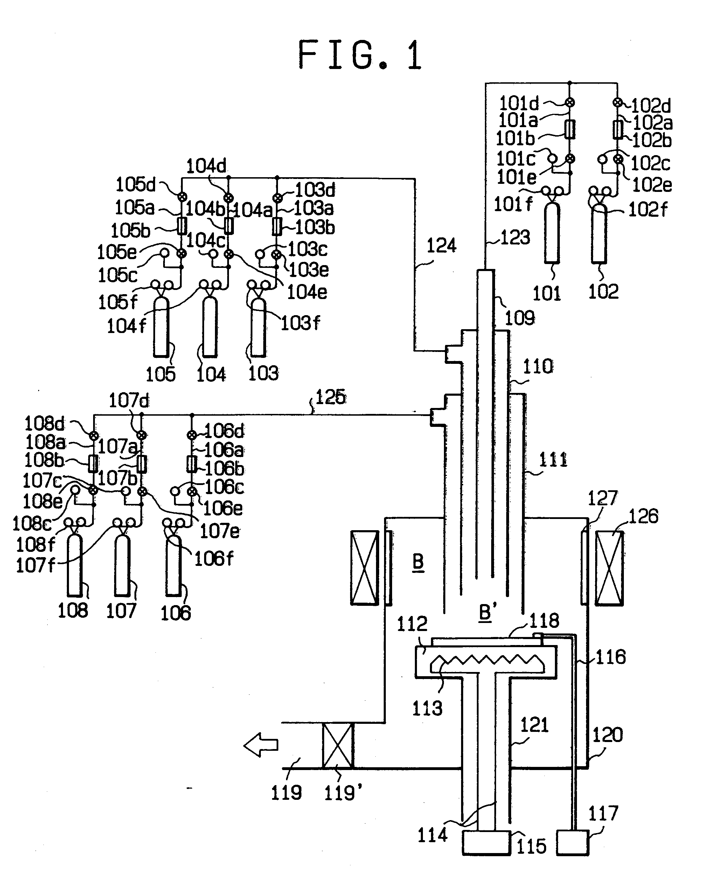

In each of the examples, the corresponding layer of the thin-film transistor is formed by using the fabrication apparatus as shown in Figure 1.

The fabrication apparatus as shown in Figure 1 comprises a reaction chamber having a film forming space for which both a gas supplying system and a gas exhausting system are provided.

In Figure 1, there are shown gas reservoirs 101 through 108, gas supplying pipe ways 101a through 108a respectively extended from the gas reservoirs 101 through 108, mass flow controllers 101b through 108b being placed respectively on the gas supplying pipe ways 101a through 108a for controlling the flow rate of gas from each of the gas reservoirs, pressure gauges 101c through 108c, main valves 101d through 108d, sub-valves 101e through 108e and gas reservoir pressure gases 101f through 108f.

Within reaction chamber 120, there are provided a first gas supplying conduit 109, a second gas supplying conduit 110 and a third gas supplying conduit 111, all of which are extended into a film forming space B of the reaction chamber 120 through an upper wall and which end leaving a space B sufficient to form a reaction region adjacent to the substrate 118 that is to be placed therein.

The first, second and third gas supplying conduits 109, 110 and 111, respectively, are provided by a concentric triple conduit having a first circular space as the first gas supplying conduit 109, a second circular space as the second gas supplying conduit 110 and a cylindrical space positioned in the middle as the third gas supplying conduit 111.

The end portion of the concentric triple conduit in the film forming space B preferably presents an inwardly cut surface and leaves a rounded space B' to act as the reaction region. The outlet of each of the gas supplying conduits 109, 110 and 111 opens downwardly.

Alternatively, the end portion of the concentric triple conduit may be structured in such a way that the outlet of the third gas supplying conduit 111 in the cylindrical form is positioned in an innermost recess and the remaining end portion, composed of the outlets of the first and second gas supplying conduits, has a diagonally cut surface form so as to leave a space in the form of conic trapezoid B' to act as the reaction region.

A gas feeding pipe 123 for the gas from the gas reservoirs 101 and 102 is connected to the first gas supplying conduit 109. A gas feeding pipe 124 for the gas from the gas reservoirs 103, 104 and 105 is connected to the second gas supplying conduit 110; and gas feeding pipe 125 for the gas from the gas reservoirs 106, 107 and 108 is connected to the third gas supplying conduit 111.

Exhaust pipe 119 is provided at the bottom part of the reaction chamber 120 having a vacuum valve 219'. The exhaust pipe 119 is connected to an exhausting device (not shown).

The air or gas in the gas feeding pipes 123, 124 and 125, the gas supplying conduits 109, 110 and 111 and the reaction chamber 120 can be evacuated by operating the exhausting device through the exhaust pipe 119.

The substrate 118 is placed on substrate holder 112 which can be shifted upwardly or downwardly with a driving means (not shown). A heater 113 for the substrate is installed in the substrate holder 112.

The heater 113 is electrically connected to an electric power source 115 through lead wires 114. A thermocouple 116, to measure the temperature of the substrate 118, is electrically connected to a temperature indicator 117 within the reaction chamber 120.

The position of the substrate 118, during film deposition, is adjusted by shifting the substrate holder 112 so that an adequate desired distance is maintained between the surface of the substrate 118 and the outlets of the gas supplying conduits 109, 110 and 111.

Such desired distance is determined properly depending upon the kind of deposited film, its expected characteristics, the flow rate of gas employed, the internal pressure in the vacuum chamber,and the like.

However, in general, this distance is preferably several millimeters to 20cm, and more preferably 5mm to 15 cm.

The heater 113 is operated usually to heat the substrate 118 to an appropriate temperature or to conduct a preliminary heat treatment of the substrate. However, the heater 113 can be used to anneal the deposited film formed on the substrate.

Example 1

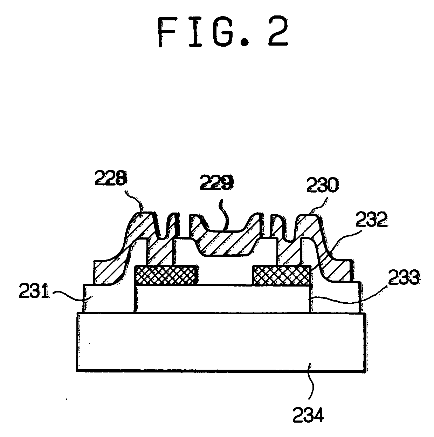

A thin-film transistor, having the structure shown in Figure 2, was prepared using the apparatus shown in Figure 1.

In Figure 2, there are shown a substrate 234, an amorphous silicon layer (first layer) 233 of 0.7 $\mu$m (7000 Å) in thickness, an amorphous silicon layer doped with P in a high concentration (second layer) 232 of 50nm (500Å) in thickness, a silicon oxide layer (third layer) 231 of 0.1 $\mu$m (1000 Å) in thickness, an aluminum gate electrode 229, a source electrode 228 and a drain electrode 230.

As the substrate 234, a 7059 glass plate (produced by Corning Glass Works), was used.

Each of the first, second and third layers was prepared respectively under the conditions shown in the following Table 1.

Table 1

| Constituting Layer | Starting Substances | Flow Rate (sccm) | Film-forming Pressure Condition (Pa) (Torr) |
|---|---|---|---|
| First Layer | $SiH_4$ <br> $F_2$ <br> He | 20 <br> 15 <br> 150 | 90 <br> (0.7) |
| Second Layer | $SiH_4$ <br> $PH_3$/He (1000ppm) <br> $F_2$ <br> He | 15 <br> 2 <br> 10 <br> 20 | 40 <br> (0.3) |
| Third Layer | $SiH_4$ <br> NO <br> $F_2$ <br> He | 20 <br> 50 <br> 15 <br> 100 | 80 <br> (0.6) |
| (Temperature of Substrate: 300°C) | | | |

An on-off ratio was measured for the resulting thin-film transistor and compared with that for a conventional thin-film transistor.

It was found that the on-off ratio for the resulting thin-film transistor was superior by about 15% to that of the conventional thin-film transistor.

Example 2

The same procedures as in Example 1 were repeated to obtain a thin-film transistor, except that $Si_2H_6$ was used instead of $SiH_4$ in forming the first layer.

It was found that the on-off ratio of the resulting thin-film transistor was superior by about 17% to that of the conventional thin film transistor.

Example 3

The same procedures as in Example 1 were repeated, except that $C_2H_4$ was used instead of NO in forming the third layer.

It was found that the on-off ratio of the resulting thin-film transistor was superior by about 14% to that of the conventional thin-film transistor.

Example 4

The same procedure as in Example 1 was repeated, except that $NH_3$ was used instead of NO in forming the third layer.

It was found that the on-off ratio of the resulting thin-film transistor was superior by about 13% to that of the conventional thin-film transistor.

**Claims**

1. A process for forming a thin-film transistor of which one of the principal semiconducting layers comprises a layer of an amorphous material, said material being prepared by
   (a) introducing into a film forming chamber containing a substrate for the thin-film transistor (i) a gaseous substance containing atoms capable of becoming constituents of said layer, and (ii) a gaseous halogen containing substance which has the property of being able to oxidise the gaseous substance (i), through separate transporting conduits,
   (b) chemically reacting the gaseous substance (i) and the halogen containing oxidising substance (ii) in the film forming chamber in the absence of a plasma, thus generating a mixture of precursors, which mixture contains precursors in an excited state, and
   (c) depositing said layer on the substrate using at least one of the precursors of said mixture.

2. A process according to claim 1, wherein the layer of an amorphous material is a silicon-containing amorphous layer and the gaseous substance (i) is a chain silane compound.

3. A process according to claim 2, wherein the chain silane compound is a straight chain silane compound.

4. A process according to claim 3, wherein the straight chain compound is a compound represented by the general formula: $Si_nH_{2n+2}$, wherein n is an integer of 1 to 8.

5. A process according to claim 3, wherein the chain silane compound is a branched chain silane compound.

6. A process according to claim 1, wherein the layer of an amorphous material is a silicon-containing amorphous layer and the gaseous substance (i) is a cyclic silane compound.

7. A process according to claim 1, wherein the layer of an amorphous material is a germanium-containing amorphous layer and the gaseous substance (i) is a chain germane compound.

8. A process according to claim 7, wherein the chain germane compound is a compound represented by the general formula: $Ge_mH_{2m+2}$,
wherein m is an integer of 1 to 5.

9. A process according to claim 1, wherein the layer of an amorphous material is a group IVA element-containing amorphous layer and the gaseous substance (i) is a compound capable of supplying atoms of group IVA element.

10. A process according to claim 1, wherein the gaseous halogen containing substance (ii) is a halogen gas selected from the group consisting of $F_2$ gas and $Cl_2$ gas.

11. A process according to claim 1, wherein the gaseous halogen containing substance (ii) is a gaseous substance containing fluorine atoms as the halogen component.

12. A process according to claim 1, wherein the gaseous halogen containing substance (ii) is under nascent state.

13. A process according to claim 1, wherein the surface of the substrate is placed so as to face the outlets of the transporting conduits for the gaseous substance (i) and the gaseous halogen containing substance (ii) in the film forming chamber.

14. A process for forming an improved thin-film transistor comprising an insulating substrate, a first layer formed from a film of non-doped amorphous semiconductive material deposited on the surface of the substrate, a second layer formed from a film of n-type impurity doped amorphous matrial, a third layer formed from a film of amorphous insulating material, a gate electrode formed from a metallic film, a source electrode formed from a metallic film and a drain electrode formed from a metallic film, the gate electrode being separated from the first layer by the third layer, the second layer being situated between the first layer and the source electrode and between the first layer and the drain electrode, which comprises the steps of:
(a) maintaining the substrate at an elevated temperature in an evacuated film-forming space;
(b) introducing (i) a gaseous substance containing atoms capable of becoming constituents of a film via a first gas transportation conduit into the evacuated film-forming space;
(c) introducing (ii) a gaseous halogen containing substance via a second gas transportation conduit, wherein the first and second gas transportation conduits are concentric and terminate adjacent to the substrate forming a reaction space, the gaseous halogen containing substance (ii) having the property of being able to oxidise the gaseous substance (i) in the reaction space to effect chemical contact therebetween and to thereby cause a chemical reaction in the absence of a plasma in the reaction space, to generate a mixture of precursors containing excited precursors, wherein at least one of the precursors form the film constituting at least one of the first, second and third layers; and
(d) maintaining the distance between the outlet of the first and second concentric gas transportation

9

conduits and the surface of the substrate from 5 millimeters to 15 centimeters.

**Revendications**

**1.** Procédé pour former un transistor à couches minces dont l'une des principales couches semi-conductrices comprend une couche d'une matière amorphe, ladite matière étant préparée par :

(a) introduction dans une chambre de formation de pellicule contenant un substrat pour le transistor à couches minces,

(i) d'une substance gazeuse contenant des atomes capables de devenir des constituants de ladite couche et (ii) d'une substance gazeuse contenant un halogène qui a la propriété d'être capable d'oxyder la substance gazeuse (i), par des conduits séparés de transport,

(b) réaction chimique de la substance gazeuse (i) et de la substance oxydante (ii) contenant un halogène dans la chambre de formation d'une pellicule en l'absence d'un plasma, de manière à engendrer ainsi un mélange de précurseurs, ledit mélange contenant des précurseurs dans un état excité, et

(c) déposition de ladite couche sur le substrat en utilisant au moins l'un des précurseurs dudit mélange.

**2.** Procédé suivant la revendication 1, dans lequel la couche d'une matière amorphe est une couche amorphe contenant du silicium et la substance gazeuse (i) est un silane à structure caténaire.

**3.** Procédé suivant la revendication 2, dans lequel le silane à structure caténaire est un silane à chaîne droite.

**4.** Procédé suivant la revendication 3, dans lequel le composé à chaîne droite est un composé représenté par la formule générale $Si_nH_{2n+2}$ dans laquelle n est un nombre entier de 1 à 8.

**5.** Procédé suivant la revendication 3, dans lequel le silane à structure caténaire est un silane à chaîne ramifiée.

**6.** Procédé suivant la revendication 1, dans lequel la couche de matière amorphe est une couche amorphe contenant du silicium et la substance gazeuse (i) est un silane cyclique.

**7.** Procédé suivant la revendication 1, dans lequel la couche de matière amorphe est une couche amorphe contenant du germanium et la substance gazeuse (i) est un germane à structure caténaire.

**8.** Procédé suivant la revendication 7, dans lequel le germane à structure caténaire est un composé représenté par la formule générale $Ge_mH_{2m+2}$, dans laquelle m est un nombre de 1 à 5.

**9.** Procédé suivant la revendication 1, dans lequel la couche de matière amorphe est une couche amorphe contenant un élément du groupe IVA et la substance gazeuse (i) est un composé capable de fournir des atomes de l'élément du groupe IVA.

**10.** Procédé suivant la revendication 1, dans lequel la substance gazeuse (ii) contenant un halogène est un halogène gazeux choisi dans le groupe constitué de $F_2$ gazeux et de $Cl_2$ gazeux.

**11.** Procédé suivant la revendication 1, dans lequel la substance gazeuse (ii) contenant un halogène est une substance gazeuse contenant des atomes de fluor comme composant halogène.

**12.** Procédé suivant la revendication 1, dans lequel la substance gazeuse (ii) contenant un halogène est à l'état naissant.

**13.** Procédé suivant la revendication 1, dans lequel la surface du substrat est disposée de manière qu'elle soit tournée vers les débouchés des conduits de transport de la substance gazeuse (i) et de la substance gazeuse (ii) contenant un halogène dans la chambre de formation de pellicule.

**14.** Procédé pour former un transistor perfectionné à couches minces comprenant un substrat isolant, une première couche formée d'une pellicule de matière semi-conductrice amorphe non dopée déposée sur la surface du substrat, une deuxième couche formée d'une pellicule de matière amorphe dopée par une impureté du type n, une troisième couche formée d'une pellicule de matière isolante amorphe, une électrode-grille formée d'une pellicule métallique, une électrode-source formée d'une pellicule métallique et une électrode-drain formée d'une pellicule métallique, l'électrode-grille étant séparée de la première couche par la troisième couche, la deuxième couche étant située entre la première couche et l'électrode-source et entre la première couche et l'électrode-drain, qui comprend les étapes consistant :

(a) à maintenir le substrat à une température élevée dans un espace vidé d'air pour la formation de pellicule ;

(b) à introduire (i) une substance gazeuse contenant des atomes capables de devenir des constituants d'une pellicule par un premier conduit de transport de gaz dans l'espace vidé d'air pour la formation de pellicule ;

(c) à introduire (ii) une substance gazeuse contenant un halogène par un second conduit de transport de gaz, les premier et second conduits de transport de gaz étant concentriques et se terminant à proximité du substrat en formant un espace de réaction, la substance gazeuse (ii) contenant un halogène ayant la propriété d'être capable d'oxyder la substance gazeuse (i) dans l'espace de réaction pour créer un contact chimique entre elles et pour provoquer ainsi une réaction chimique en l'absence d'un plasma dans l'espace de réaction, afin d'engendrer un mélange de précurseurs contenant des précurseurs excités, l'un au moins des précurseurs de la pellicule constituant au moins l'une des première, deuxième et troisième couches ; et

(d) à maintenir la distance entre le débouché des premier et second conduits concentriques de transport de gaz et la surface du substrat entre 5 millimètres et 15 centimètres.

**Patentansprüche**

1. Verfahren zur Herstellung eines Dünnfilm-Transistors, bei dem eine der Haupt-Halbleiterschichten eine Schicht eines amorphen Materials umfaßt, wobei das Material hergestellt wird, indem

(a) in eine Filmbildungskammer, die einen Täger für den Dünnfilmtransistor enthält, (i) eine gasförmige Verbindung, welche zur Bildung von Bestandteilen der Schicht befähigte Atome enthält, und (ii) eine gasförmige, halogenhaltige Verbindung, welche die Eigenschaft besitzt, die gasförmige Verbindung (i) oxidieren zu können, durch getrennte Transportleitungen eingeführt werden,

(b) die gasförmige Verbindung (i) mit der halogenhaltigen, oxidierenden Verbindung (ii) in der Filmbildungskammer in Abwesenheit eines Plasmas umgesetzt wird, um eine Mischung aus Vorläuferverbindungen zu erzeugen, wobei die Mischung Vorläuferverbindungen im angeregten Zustand enthält, und

(c) die Schicht auf dem Träger unter Verwendung mindestens eines der Vorläuferverbindungen der Mischung aufgetragen wird.

2. Verfahren nach Anspruch 1, dadurch gekennzeichnet, daß die Schicht eines amorphen Materials eine siliciumhaltige amorphe Schicht ist, und daß die gasförmige Verbindung (i) eine Ketten-Silanverbindung ist.

3. Verfahren nach Anspruch 2, dadurch gekennzeichnet, daß die Ketten-Silanverbindung eine Geradketten-Silanverbindung ist.

4. Verfahren nach Anspruch 3, dadurch gekennzeichnet, daß die Geradketten-Verbindung eine durch die allgemeine Formel $Si_nH_{2n+2}$ dargestellte Verbindung ist, wobei n eine ganze Zahl von 1 bis 8 ist.

5. Verfahren nach Anspruch 2, dadurch gekennzeichnet, daß die Ketten-Siliciumverbindung eine Verzweigtketten-Silanverbindung ist.

6. Verfahren nach Anspruch 1, dadurch gekennzeichnet, daß die Schicht eines amorphen Materials eine siliciumhaltige amorphe Schicht ist und die gasförmige Verbindung (i) eine zyklische Silanverbindung ist.

7. Verfahren nach Anspruch 1, dadurch gekennzeichnet, daß die Schicht eines amorphen Materials eine germaniumhaltige, amorphe Schicht ist und die gasförmige Verbindung (i) eine Ketten-Germanverbindung ist.

**8.** Verfahren nach Anspruch 7, dadurch gekennzeichnet, daß die Ketten-Germaniumverbindung eine durch die allgemeine Formel $Ge_mH_{2m+2}$ dargestellte Verbindung ist, wobei m eine ganze Zahl von 1 bis 5 ist.

**9.** Verfahren nach Anspruch 1, dadurch gekennzeichnet, daß die Schicht eines amorphen Materials eine amorphe Schicht ist, die ein Element der Gruppe IVA enthält, und die gasförmige Verbindung (i) eine Verbindung ist, die befähigt ist, Atome eines Gruppe IVA-Elements zuzuführen.

**10.** Verfahren nach Anspruch 1, dadurch gekennzeichnet, daß die gasförmige, halogenhaltige Verbindung (ii) ein aus der aus $F_2$-Gas und $Cl_2$-Gas bestehenden Gruppe ausgewähltes Halogengas ist.

**11.** Verfahren nach Anspruch 1, dadurch gekennzeichnet, daß die gasförmige, halogenhaltige Verbindung (ii) eine gasförmige Verbindung ist, die Fluoratome als Halogenkomponente enthält.

**12.** Verfahren nach Anspruch 1, dadurch gekennzeichnet, daß sich die gasförmige, halogenhaltige Verbindung (ii) im naszierenden Zustand befindet.

**13.** Verfahren nach Anspruch 1, dadurch gekennzeichnet, daß die Oberfläche des Trägers so plaziert wird, daß diese in der Filmbildungskammer den Auslässen der Transportleitungen für die gasförmige Verbindung (i) und für die gasförmige, halogenhaltige Verbindung (ii) gegenüberliegt.

**14.** Verfahren zur Herstellung eines verbesserten Dünnfilm-Transistors, der einen isolierenden Träger, eine auf die Oberfläche des Trägers aufgebrachte und aus einem Film aus einem nicht-dotierten, amorphen Halbleitermaterial gebildete erste Schicht, eine aus einem Film aus einem amorphen, mit einer Verunreinigung vom n-Typ dotierten Material gebildete zweite Schicht, eine aus einem Film aus amorphem, isolierendem Material gebildete dritte Schicht, eine aus einem metallischen Film gebildete Gate- bzw. Steuerelektrode, eine aus einem metallischen Film gebildete Source- bzw. Quellelektrode, eine aus einem metallischen Film gebildete Drain- bzw. Senkelektrode umfaßt, wobei die Gate- bzw. Steuerelektrode von der ersten Schicht durch die dritte Schicht getrennt ist, die zweite Schicht zwischen der ersten Schicht und der Source- bzw. Quellelektrode und zwischen der ersten Schicht und der Drain-bzw. Senkelektrode angebracht ist, umfassend die folgenden Schritte:
(a) Halten des Trägers bei einer erhöhten Temperatur in einem evakuierten Filmbildungsraum,
(b) Einführen einer gasförmigen Verbindung (i), welche zur Bildung von Bestandteilen einer Schicht befähigte Atome enthält, über eine erste Gas-Transportleitung in den evakuierten Filmbildungsraum,
(c) Einführen einer gasförmigen, halogenhaltigen Verbindung (ii) über eine zweite Gas-Transportleitung, wobei die Leitungen der ersten und zweiten Gastransportleitung konzentrisch verlaufen und benachbart zu dem Träger enden, dabei einen Reaktionsraum bildend, wobei die gasförmige, halogenhaltige Verbindung (ii) die Eigenschaft hat, die gasförmige Verbindung (i) im Reaktionsraum oxidieren zu können, um zwischen diesen einen chemischen Kontakt zu bewirken, und um dadurch eine chemische Reaktion in Abwesenheit eines Plasmas im Reaktionsraum zu verursachen, zur Erzeugung einer Mischung von Vorläufern, die Vorläufer im angeregten Zustand enthalten, wobei mindestens einer der Vorläufer den Film bilden, der mindestens eine der ersten, zweiten und dritten Schichten darstellt, und
(d) Halten der Entfernung zwischen den Auslässen der ersten und zweiten konzentrischen Gas-Transportleitungen und der Oberfläche des Trägers auf 5 mm bis 15 cm.

# FIG. 1

# FIG. 2